# EUROPÄISCHE PATENTSCHRIFT

(11) **EP 0 602 612 B1**
(45) Veröffentlichungstag und Bekanntmachung des Hinweises auf die Patenterteilung: **01.09.1999**
(21) Anmeldenummer: 93120159.4
(22) Anmeldetag: 14.12.1993
(51) Int. Cl.: H01L 29/74, H01L 29/10

(54) **GTO-Thyristor**
GTO Thyristor
Thyristor GTO

(30) Priorität: 17.12.1992 DE 4242809
(43) Veröffentlichungstag der Anmeldung: 22.06.1994
(73) Patentinhaber: SIEMENS AKTIENGESELLSCHAFT, 80333 München (DE)
(72) Erfinder: Dr. Gross, Wolfgang, D-85452 Moosinning (DE); Willmeroth, Armin, D-86163 Augsburg (DE)

(56) Entgegenhaltungen:
- EP-A- 0 160 525
- EP-A- 0 466 101
- PESC '89 - 20TH ANNUAL IEEE POWER ELECTRONICS SPECIALISTS CONFERENCE Juni 1989 , MILWAUKEE WI USA Seiten 330 - 336 XP44300 MITSURU KEKURA ET AL. '8000V 1000A GATE TURN-OFF THYRISTOR WITH LOW ON-STATE VOLTAGE AND LOW SWITCHING LOSS'
- Thyristor Design and Realization. P.Taylor, pub. J.Wiley 1987, Seiten 28-35

## Beschreibung

Die Erfindung bezieht sich auf einen GTO-Thyristor mit einem Halbleiterkörper mit einer schwach dotierten Mittelzone vom ersten Leitungstyp, an die anodenseitig eine stärker dotierte Emitterzone vom zweiten Leitungstyp und Kurzschlußzonen vom ersten Leitungstyp angrenzen.

GTO-Thyristoren dieser Art sind z.B. in der EP 0 160 525 B1 und der EP 0 366 916 A2 beschrieben worden.

Die EP 0 160 525 A2 beschreibt einen GTO-Thyristor mit einer schwach dotierten Mittelzone vom ersten Leitungstyp (n), an die anodenseitig eine Emitterzone vom zweiten Leitungstyp (p) und Kurzschlußzonen vom ersten Leitungstyp (n⁺) angrenzen. Es wird eine Methode beschrieben, in der Gold in einem vorbestimmten Temperaturbereich in die n-Basis eindiffundiert wird, wobei hierdurch verringerte Abschaltverluste ohne Erhöhung der Durchlaßverluste erzielt werden.

Bekannte GTO-Thyristoren der genannten Art sind im allgemeinen zur Verringerung von Durchlaßverlusten so dimensioniert, daß ihre maximale Sperrspannung in Vorwärtsrichtung nur wenig über der in Vorwärtsrichtung geforderten Nennsperrspannung liegt. Diese maximale Nennsperrspannung ist durch die Avalanche-Feldstärke begrenzt, die im Volumen bei etwa 1,5 x 10⁵ V/cm liegt, an der Oberfläche des Halbleiterkörpers jedoch erheblich darunter.

Werden solche GTO-Thyristoren in Umrichterschaltungen betrieben, in denen sie ständig an Gleichspannung liegen, können sie spontan ausfallen, wenn sie mit einer Vorwärts-Nennsperrspannung betrieben werden, die bis zu 20 % unter der maximalen Sperrspannung liegt. Die genaue Ursache hierfür ist noch nicht vollständig geklärt. Aus der Tatsache, daß diese Ausfälle spontan und relativ selten auftreten, läßt sich vermuten, daß hier die Höhenstrahlung eine Rolle spielt. Diese erzeugt offensichtlich Mikroplasmen, die die GTO-Thyristoren in den Avalanche-Durchbruch treiben.
Ziel der Erfindung ist es, einen GTO-Thyristor der erwähnten Gattung derart weiterzubilden, daß diese spontanen Ausfälle bei vergleichbaren Durchlaßverlusten vermieden werden.

Dieses Ziel wird dadurch erreicht, daß die Mittelzone
a) eine Dotierung hat, die mindestens für das 1,3fache der Nennsperrspannung in Vorwärtsrichtung ausgelegt ist,
b) eine solche Dicke hat, daß die Punch-Throughspannung höchstens um 20 % größer ist als die genannte Nennsperrspannung.

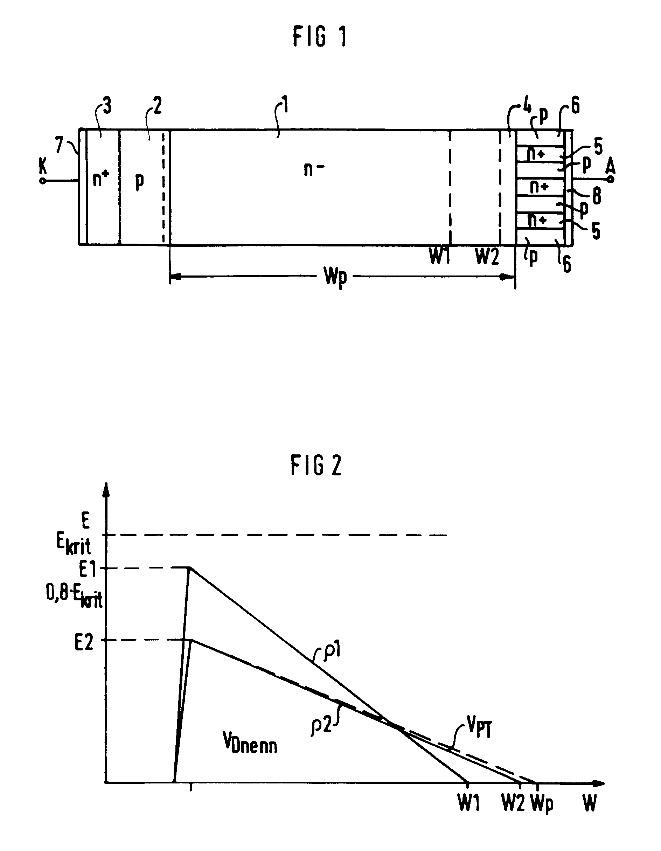

Die Erfindung wird anhand einiger Ausführungsbeispiele in Verbindung mit den Figuren 1 und 2 näher erläutert. Es zeigen:
- Figur 1: die schematische Ansicht eines Halbleiterkörpers eines GTO-Thyristors und
- Figur 2: den Feldstärkeverlauf in Abhängigkeit der Dicke der Mittelzone bei einem GTO-Thyristor nach dem Stand der Technik und bei einem GTO-Thyristor nach der Erfindung.

Der GTO-Thyristor nach Figur 1 hat einen Halbleiterkörper mit einer schwach n-dotierten Mittelzone 1, an die katodenseitig eine p-dotierte Zone 2 mit höherer Dotierung angrenzt. An diese wiederum grenzt eine Katodenemitterzone 3 an, die stark n-dotiert ist. Sie ist mit einer Katodenelektrode 7 verbunden. Auf der anderen Seite grenzt an die Mittelzone 1 eine p-dotierte Anodenemitterzone 6, in deren Fläche stark n-dotierte Kurzschlußzonen 5 angeordnet sind. Die Zonen 5 und 6 sind mit einer Anodenelektrode 8 verbunden. Die Kurzschlußzonen dienen analog den katodenseitigen Kurzschlußzonen bei einem normalen Thyristor dazu, die stromabhängige Stromverstärkung des Thyristors derart einzustellen, daß ein definiertes Zünden möglich ist.

Bei konventionellen GTO-Thyristoren der erwähnten Art wird die Dotierung der Mittelzone 1 derart eingestellt, daß die mit Eₖᵣᵢₜ erreichbare Sperrspannung maximal 25 % über den Nennsperrspannung liegt. (Der Zusammenhang zwischen der Dotierung und Eₖᵣᵢₜ ist aus der Literatur bekannt.) Bei Anliegen der Nennsperrspannung tritt dann eine maximale Feldstärke E₁ auf, die mindestens bei ca. 90 % von Eₖᵣᵢₜ oder darüber liegt, bei den maximal auftretenden Betriebsspannungen sind es immer noch ca. 85 % von Eₖᵣᵢₜ. Der der gewählten Dotierung entsprechende spezifische Widerstand ist in Figur 2 mit ξ1 bezeichnet. Die Raumladungszone dehnt sich dann in der Mittelzone 1 beginnend vom zwischen den Zonen 1 und 2 liegenden pn-Übergang über eine Breite W1 aus. Da hier die Spitzenfeldstärke El am pn-Übergang relativ nah an der kritischen Feldstärke liegt, kann ein solcher GTO-Thyristor in den eingangs erwähnten Fällen in den Avalanche-Durchbruch gehen. Er ist damit zerstört.

Die Dotierung des erfindunsgemäßen GTO-Thyristors wird nun derart gewählt, daß sie mindestens für das 1,3fache der Nennsperrspannung in Vorwärtsrichtung ausgelegt ist. Das heißt, daß der spezifische Widerstand größer gewählt wird, als dies für die gewählte Spannungsklasse (Nennsperrspannung in Vorwärtsrichtung) notwendig wäre. In Figur 2 ist dieser spezifische Widerstand mit ξ2 bezeichnet. Da die Feldstärke nun flacher vom pn-Übergang zwischen den Zonen 1 und 2 in Richtung zur Anode abfällt, erstreckt sich die Raumladungszone vom genannten pn-Übergang über eine Dicke W2 in die Mittelzone 1 hinein. Die Dicke W2 der Raumla- dungszone ist bei der Nennsperrspannung in Vorwärtsrich- tung V_{Dnenn} kleiner als die gesamte Dicke Wₚ der Mittel- zone 1. Bei einer Erhöhung der Sperrspannung würde sich die Raumladungszone weiter ausdehnen, bis sie an die Anodenemitterzone anstößt. Damit würde dann die Punch-Throughspannung erreicht, bei der der GTO-Thyristor seine Sperrfähigkeit verliert. Da die bei dieser Dimensionierung im Betrieb auftretenden Feldstärken unter 0,8 Eₖᵣᵢₜ blei- ben, wird die Zerstörung des Thyristors vermieden. Aus Gründen einer Minimierung der Durchlaßverluste wird die Dicke Wₚ höchstens so groß gewählt, daß die Punch-Throughspannung höchstens um 20 % größer ist als die Nennsperrspannung.

Als zweckmäßig hat es sich erwiesen, die Dotierung der Mittelzone für etwa das 1,4fache der Nennsperrspannung auszulegen. Die Mittelzone wird dabei derart bemessen, daß die Punch-Throughspannung V_{PT} um etwa 10 % größer ist als die Nennsperrspannung.

Nachfolgend werden einige Ausführungsbeispiele mit den wesentlichen Parametern, Nennsperrspannung, spezifischer Widerstand, Weite der Mittelzone, Punch-Throughspannung angegeben.

| Spannungsklasse (VDnenn) | VDmax | ζ-Wert | n-Basis-Weite |
|---|---|---|---|
| kV | kV | Ohm cm | µm |
| 2,5 | 3,5 | 125 | 320 |
| 4,5 | 6,3 | 270 | 630 |
| 6 | 8,4 | 400 | 900 |

| | V_{PT} | E(Avalanche) | VDmax/ VDnenn |
|---|---|---|---|
| | kV | kV/cm | |
| | 2,75 | 188 | 1,4 |
| | 5 | 175,5 | 1,4 |
| | 7,2 | 166,6 | 1,4 |

## Patentansprüche

1. GTO-Thyristor mit einem Halbleiterkörper mit einer schwach dotierten Mittelzone (1) vom ersten Leitungstyp, an die anodenseitig eine stärker dotierte Emitterzone (5) vom zweiten Leitungstyp und Kurzschlußzonen (6) vom ersten Leitungstyp angrenzen,
**dadurch gekennzeichnet,** daß die Mittelzone (1)
a) eine Dotierung hat, die mindestens für das 1,3fache der Nennsperrspannung in Vorwärtsrichtung ausgelegt ist,
b) eine solche Dicke hat, daß die Punch-Throughspannung höchstens um 20 % größer ist als die genannte Nennsperrspannung.

2. GTO-Thyristor nach Anspruch 1,
**dadurch gekennzeichnet,** daß die Dotierung der Mittelzone (1) für etwa das 1,4fache der Nennsperrspannung ausgelegt ist und daß die Mittelzone eine Dicke hat, daß die Punch-Throughspannung um etwa 10 % größer ist als die Nennsperrspannung.

## Revendications

1. Thyristor GTO comprenant un corps semi-conducteur présentant une zone centrale (1) du premier type de conduction faiblement dopée, qui est contiguë, sur le côté de l'anode, à une zone d'émetteur (5) du second type de conduction plus fortement dopée et à des zones de court-circuit (6) du premier type de conduction, caractérisé en ce que la zone centrale (1)
a) a un dopage qui est étudié au moins pour 1,3 fois la tension de blocage nominale dans le sens direct,
b) a une épaisseur telle que la tension de claquage soit supérieure de 20% au maximum à la tension de blocage nominale mentionnée.

2. Thyristor GTO selon la revendication 1, caractérisé en ce que le dopage de la zone centrale (1) est étudié pour environ 1,4 fois la tension de blocage nominale et en ce que la zone centrale a une épaisseur telle que la tension de claquage soit supérieure d'environ 10% à la tension de blocage nominale.

## Claims

1. GTO thyristor having a semiconductor body having a weakly doped central zone (1) of the first conduction type, which is adjoined on the anode side by a more heavily doped emitter zone (5) of the second conduction type and short-circuit zones (6) of the first conduction type,
characterized in that the central zone (1)
a) has a doping which is designed at least for 1.3 times the rated blocking voltage in the forward direction,
b) has a thickness such that the punch-through voltage is at most 20% greater than the said rated blocking voltage.

2. GTO thyristor according to Claim 1, characterized in that the doping of the central zone (1) is designed for approximately 1.4 times the rated blocking voltage, and in that the central zone has a thickness such that the punch-through voltage is approximately 10% greater than the rated blocking voltage.
